# EUROPEAN PATENT APPLICATION

(11) **EP 4 576 197 A1**
(43) Date of publication of application: **25.06.2025**
(21) Application number: 24212339.6
(22) Date of filing: 12.11.2024
(51) Int. Cl.: H01L 23/367, H01L 23/373, H01L 23/433, H05K 1/02, H05K 3/34

(54) **APPARATUS AND METHOD FOR THERMAL MANAGEMENT OF HIGH-POWER ELECTRONIC COMPONENTS USING GRAPHITE BARS**

(30) Priority: 22.12.2023 US 202363614236 P
(71) Applicant: MacDonald, Dettwiler and Associates Corporation, Ste-Anne-de-Bellevue, QC H9X 3R2 (CA)
(72) Inventor: Megahed, Ayman, Sainte-Anne-de-Bellevue, Quebec, H9X 3R2 (CA); Salama, Marianne, Sainte-Anne-de-Bellevue, Quebec, H9X 3R2 (CA); Kamal, Walid, Sainte-Anne-de-Bellevue, Quebec, H9X 3R2 (CA)
(74) Representative: Grünecker Patent- und Rechtsanwälte PartG mbB

(57) **Abstract**

A cooling apparatus is provided, including a graphite bar mounted to a frame, the graphite bar thermally conductive in perpendicular first and second axes, the second axis parallel to a length of the graphite bar, the frame for mounting the at least one graphite bar, the frame including a receiving and retaining member mounted thereon and thermally coupled thereto for retaining the graphite bar in a fixed position relative to the frame, the receiving and retaining member including a recess for receiving the graphite bar, a thermal adhesive disposed in the recess for adhering and thermally coupling the graphite bar to the receiving and retaining member, and a heat sink thermally coupled to the frame. Heat is extracted from the graphite bar or flows downward through the graphite bar along the second axis to the receiving and retaining member, to the frame, and to the heat sink.

## Description

### Technical Field

The following relates generally to thermal management in space applications, and more particularly to thermal management of high-power flip chip electronic components.

### Introduction

Cooling of computer components, for example of high-power microprocessors, is an important consideration in operability and survivability of the computer components. Power dissipation of flip-chip electronic components, such as field-programming gate arrays (FPGAs), ball grid arrays (BGAs), column grid arrays (CCGAs), and others, has dramatically increased in the past decade with more severe design requirements like data retention. The importance of thermal management and limiting thermal fatigue of electronic components is particularly challenging in space-based applications. A key goal of enabling spaceflight, in particular electronic components of, in, or for a spacecraft, is providing effective thermal control that mitigates or avoids thermal fatigue and thermal run away.

Flip-chip electronic components refer to electronics where the die (for dissipating heat) is sandwiched between the substrate and the lid. Accordingly, the main heat path of flip-chip electronic components is from the die to the lid, which is approximately 10 times more efficient than the path from the die to the columns through the substrate.

One approach to thermal management of electronic components in space applications is to use heat pipes. Heat pipes are, however, complicated to assemble, implement, maintain, and operate efficiently at low temperatures. These disadvantages cause inefficiencies when used with computer components such as high-power microprocessors. Moreover, where the computer components are deployed in an environment that does not permit easy maintenance or reassembly, such as on board a satellite in orbit, these disadvantages may cause outright failure of the computer components. Disadvantages include, for example, high cost, extensive screening, adverse gravity effect, greater design complexity, and more complex assembly sequence.

Another approach to thermal management of electronic components in space applications is to use thermal straps. Conventional thermal straps demonstrate poor thermal performance and/or heavy mass. Copper straps provide double the thermal performance compared to aluminum straps but with a heavy mass penalty, as copper straps are approximately 3 times heavier than aluminum straps and graphite straps.

A specific approach to thermal straps is the use of graphite straps, which provide approximately 3 times the thermal conductivity of copper straps with more than 70% savings in mass. However, graphite strips are composed of thin graphite layers that may not be oriented in the direction of heat flow.

Accordingly, there is a need for an improved system, apparatus, and method for managing thermal output of flip chip electronic components in space-based applications, such as satellite onboard processors using digital processing components, that overcomes the disadvantages of existing systems and methods.

### Summary

A cooling apparatus for cooling electronic components is provided, the cooling apparatus including at least one graphite bar mounted to a frame, the at least one graphite bar thermally conductive in a first axis and a second axis, the second axis being perpendicular to the first axis, the second axis parallel to a length of the at least one graphite bar, the frame for mounting the at least one graphite bar, the frame including a receiving and retaining member mounted thereon and thermally coupled thereto for retaining the at least one graphite bar in a fixed position relative to the frame, the receiving and retaining member including a recess for receiving the at least one graphite bar, a thermal adhesive disposed in the recess for adhering and thermally coupling the at least one graphite bar to the receiving and retaining member, and a heat sink thermally coupled to the frame. Heat is extracted from the at least one graphite bar or flows downward through the at least one graphite bar along the second axis to the receiving and retaining member, to the frame, and to the heat sink.

The cooling apparatus may further include a digital printed circuit board ("PCB") mounted to a PCB mounting platform to which the frame is mounted and thermally coupled.

The cooling apparatus may further include a flip chip electronic component mounted to the PCB at a bottom surface of the at least one graphite bar, the flip chip electronic component including an integrated circuit package, a top surface for dissipating heat to the at least one graphite bar, and a plurality of soldered contacts deposited onto chip pads of the flip chip electronic component for interconnecting the flip chip electronic component to external circuitry on the PCB, and a flexible adhesive disposed between a portion of the bottom surface of the at least one graphite bar overlapping the top surface of the flip chip electronic component.

Approximately one third of the bottom surface of the at least one graphite bar may overlap the top surface of the flip chip electronic component.

The flexible adhesive may be applied with a primer to enhance bonding.

The plurality of soldered contacts may be soldered columns.

The soldered columns may be wrapped in copper.

The plurality of soldered contacts may be soldered balls.

The at least one graphite bar may not be conductive in a third axis perpendicular to the first axis and further perpendicular to the second axis.

The at least one graphite bar may be further conductive in a third axis perpendicular to the first axis and further perpendicular to the second axis.

The at least one graphite bar may be composed of polycrystalline graphite.

The polycrystalline graphite may be quantumly oriented such that conductivity is possible only in the first axis and in the second axis.

The polycrystalline graphite may be annealed.

The at least one graphite bar may be substantially rigid.

The at least one graphite bar may be compliant.

Other aspects and features will become apparent, to those ordinarily skilled in the art, upon review of the following description of some exemplary embodiments.

### Brief Description of the Drawings

The drawings included herewith are for illustrating various examples of articles, methods, and apparatuses of the present specification. In the drawings:
Figure 1A is schematic side view of a system for thermally controlling flip chip electronic components of a digital printed circuit board (PCB) in a spacecraft platform, according to an embodiment;
Figure 1B is a schematic side view of the system of Figure 1A showing heat flow through the system;
Figure 2A is a top view of the system of Figures 1A and 1B;
Figure 2B is an isometric view of the system of Figures 1A and 1B; and
Figure 3 is a flow diagram of a method of assembling a system for thermally controlling flip chip electronic components, according to an embodiment.

### Detailed Description

Various apparatuses or processes will be described below to provide an example of each claimed embodiment. No embodiment described below limits any claimed embodiment and any claimed embodiment may cover processes or apparatuses that differ from those described below. The claimed embodiments are not limited to apparatuses or processes having all of the features of any one apparatus or process described below or to features common to multiple or all of the apparatuses described below.

Further, although process steps, method steps, algorithms or the like may be described (in the disclosure and / or in the claims) in a sequential order, such processes, methods and algorithms may be configured to work in alternate orders. In other words, any sequence or order of steps that may be described does not necessarily indicate a requirement that the steps be performed in that order. The steps of processes described herein may be performed in any order that is practical. Further, some steps may be performed simultaneously.

When a single device or article is described herein, it will be readily apparent that more than one device / article (whether or not they cooperate) may be used in place of a single device / article. Similarly, where more than one device or article is described herein (whether or not they cooperate), it will be readily apparent that a single device / article may be used in place of the more than one device or article.

The following relates generally to thermal management in space applications, and more particularly to thermal management of high-power flip chip electronic components.

The present disclosure provides systems, apparatus, and methods for efficiently cooling high-power electronic components in space applications using highly conductive graphite bars. The present disclosure is particularly suited to thermal management of flip chip electronic components, such as may be found in onboard processors of satellite or other spacecraft that use digital PCB. The graphite bars provide a thermal management solution that may provide various advantages, such as ease of manufacturing and assembly and providing high thermal conductivity with relatively low mass. The graphite bars provide more than twice the thermal-conductance-to-mass ratio compared with other graphite thermal management solutions (e.g., graphite thermal straps). The thermal management solution provided by the present disclosure can, in an embodiment, handle more than double the power dissipation (e.g., in a flip chip context) of some conventional solutions and the same as copper water heat pipes.

The present disclosure may have further applications in efficiently cooling digital PCBs and other onboard digital processors.

The present disclosure advantageously achieves a balance between thermal performance, mass, and thermal fatigue/life expectancy of a flip chip electronic component, such as an FPGA. The present disclosure advantageously achieves lower costs and a simpler design and assembly.

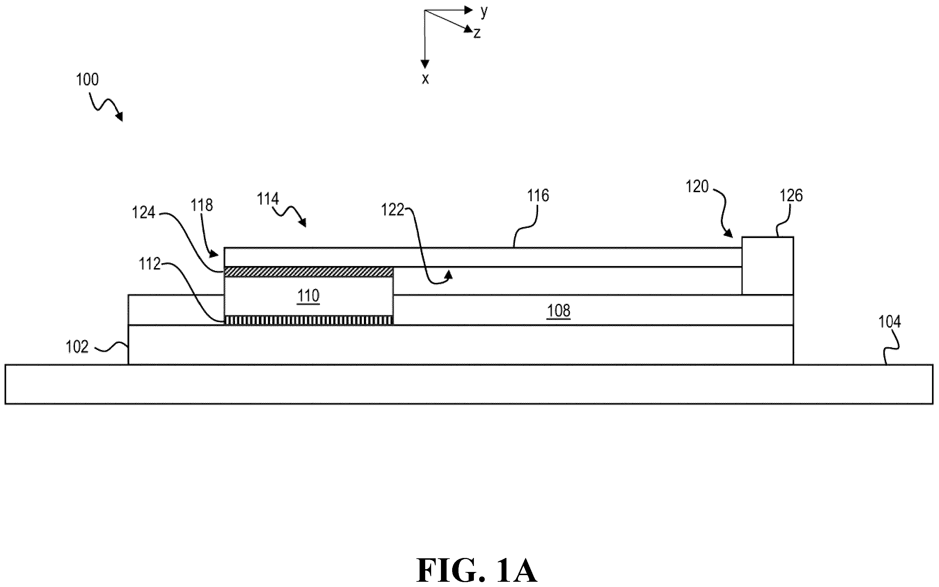

Referring now to Figure 1A, shown therein is a system 100 for managing a thermal output of a high-power electronic component of a digital PCB on a spacecraft platform, according to an embodiment.

For clarity, Figure 1A includes the x, y, and z axes labelled as such.

The system 100 may be used in space-based applications (e.g., onboard a satellite or other spacecraft) to thermally manage a digital PCB, such as in an onboard digital processor. Such processing components may be subject to thermal fatigue conditions during missions, which can negatively impact performance, survival, and thermal runaway.

The system 100 includes a digital processing unit including a digital printed circuit board ("PCB") 102 mounted to a PCB mounting platform 104. The PCB mounting platform 104 is a housing into which the PCB 102 is installed. The PCB mounting platform or housing 104 may be mounted to a platform or panel of a satellite or other spacecraft, or a separate component mounted thereon.

The system 100 further includes a frame 108 including a plurality of connected horizontal frame components and vertical frame components. The frame 108 may form a grid-type structure. The frame 108 is mounted to the digital PCB 102. In some cases, the frame may be coupled (thermally and/or mechanically) to the PCB housing 104. The frame 108 provides structural support and a conductive thermal heat path for PCB-mounted components.

The system 100 further includes a flip chip package (also referred to as a flip chip electronic component) mounted to the digital PCB 102. The flip chip package includes a processing chip 110 (or integrated circuit package 110) and a plurality of soldered contacts 112. The flip chip package may be considered a high power electronic component. Such components dissipate heat through a top surface of the package (such a direction being termed the +x direction in this disclosure and such axis being considered the x axis in this disclosure).

The soldered contacts 112 are deposited onto chip pads of the processing chip 110 and interconnect the chip 110 to external circuitry on the digital PCB 102.

The flip chip package sinks heat from the chip 110 via the soldered contacts 112. Roughly 10% of the heat goes through the soldered contact so it is not an efficient heat path.

In an embodiment, the flip chip package may be a flip chip FPGA. In another embodiment, the flip chip package may be a column grid array (CGA or CCGA). In another embodiment, the flip chip package may be a ball-grid array (BGA).

The soldered contacts 112 may be, for example, soldered columns, soldered balls, or any other suitable soldered contact. In an embodiment, the soldered contacts 112 are copper wrapped solder columns. Soldered columns may provide more compliancy than solder balls to reduce stress caused by CTE mismatch. The solder columns may absorb stress and increase solder joint reliability under harsh operating conditions.

Copper-wrapped solder columns as embodiments of the contacts 112 may advantageously extend an effective operating life of the soldered contacts 112.

The system 100 further includes a thermal management apparatus 114 for managing heat generated by the flip chip package. Generally, by managing thermal output, the thermal management apparatus 114 reduces likelihood of a thermal fatigue (in particular of soldered contacts 112) condition in the flip chip package. In this way, the thermal management apparatus 114 extends the operating life of the flip chip package.

The thermal management apparatus 114 includes a plurality of graphite bars 116. In an embodiment, the number of graphite bars 116 is two. In other embodiments, another number of graphite bars 116 may be used. The number of graphite bars 116 used may be determined based on the flip chip package size and/or flip chip package power dissipation. The width of each graphite bars 116 may be a limiting factor and so may determine the number of bars 116 based on power dissipation and size of an FPGA.

In the particular embodiment shown in Figure 1A, there are two graphite bars 116 disposed side by side. Note that due to the side view of Figure 1A, the second graphite bar is obscured but is understood to be present. The graphite bars 116 may be disposed such that there is a (small) gap between the edges of the respective graphite bars 116 along their length (not shown).

The graphite bars 116 are generally rectangular in shape. The graphite bars 116 may each have the same dimensions.

The graphite bars 116 each have a length defined by a first end 118 and a second end 120. A bottom surface 122 of the graphite bars 116 is used to mount the graphite bars 116 to a top surface of the processing chip 110 of the flip chip package.

In an embodiment, approximately one third of the bottom surface 122 towards the first end 118 of the graphite bars 116 is mounted to the processing chip 110. In other embodiments, the proportion of the graphite bars 116 covering or mounted to the processing chip 110 may vary depending on package size.

Generally, the graphite bars 116 may be mounted to the processing chip 110 such that as much surface area of the top surface of the processing chip 110 is covered by the graphite bars 116. For example, the graphite bars 116 may be mounted such that an entire surface area or near entire surface of the processing chip 110 is covered. Doing so allows for a greater heat path out of the flip chip package 110.

Accordingly, in some embodiments, the number and size of the graphite bars 116 may be based on the surface area of the top surface of the processing chip 110 and dissipated power.

It will be appreciated by one of skill in the art that different thicknesses of the graphite bars 116 may be used according to the specific application in which the bars 116 are deployed (e.g., in a high-power flip-chip FPGA, in a PCB). The shorter the bars 116 are, the better the fatigue survivability thereof may be because less stress may be imparted to shorter bars 116 due to decrease in thermal distortion.

In some embodiments, the bars 116 may be substantially or completely rigid. In some embodiments, the bars 116 may be compliant. Some compliance may be preferred over rigidity to avoid inducing parasitic loads in the solder. Graphite bars are naturally rigid, with flexible adhesive minimizing the rigidity effect of the graphite bars.

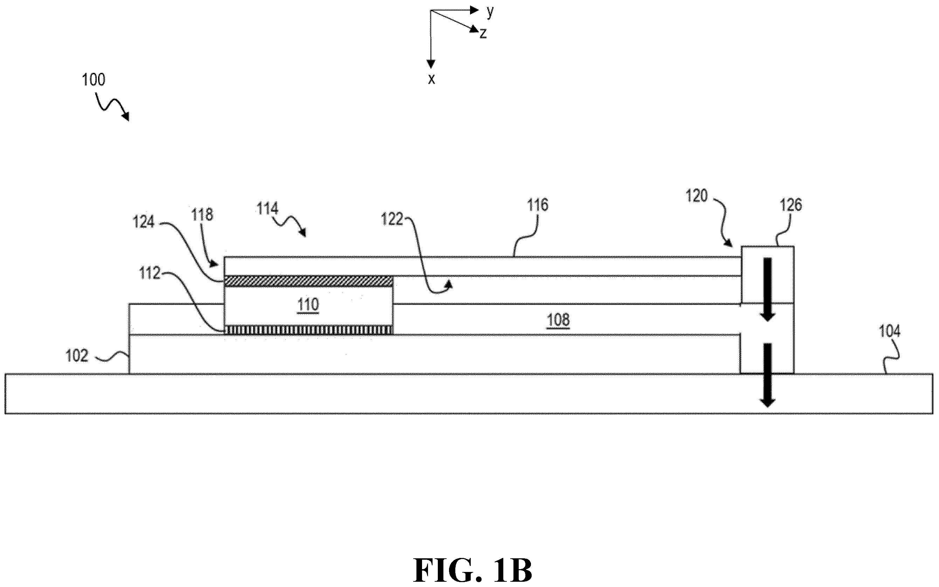

Graphite straps are ordinarily made of flexible sheets conductive in the y-z plane as labelled in Figures 1A, 1B.

In an embodiment, the bars 116 are made of rigid sheets conductive in the x-y plane. The bars 116 advantageously perform better thermally because the x-y planar conductivity permits heat to be extracted in the x axis. Advantageously, the x-y planar conductivity further permits heat to flow down along the y axis.

In an embodiment, the bars 116 are made of polycrystalline graphite. Polycrystalline graphite is naturally conductive in two axes out of the x, y, and z axes. In an embodiment, the polycrystalline graphite is oriented such that the bars 116 are conductive in the x-y plane but not the x-z or y-z planes.

In an embodiment, the bars 116 are conductive along each of the x, y, and z axes at once, i.e., in each of the x-y, x-z, and y-z planes at once. The graphite bars 116 may be isotropic with respect to conductivity in each of the x, y, and z axes. While x-y-z conductivity may be used, thermal conductivity may decrease (e.g., from 1700 W/m·K to 1200 W/m·K).

In an embodiment, in order to prepare the bars 116 to be conductive as hereinabove described, the polycrystalline graphite is quantumly oriented so that only the selected heat conductivity is possible (e.g., x-y conductivity) as hereinabove described.

In an embodiment, in order to prepare the bars 116 to be conductive as hereinabove described, the polycrystalline graphite is annealed.

In an embodiment, the bars 116 are relatively short in order to reduce stress thereon and improve survival thereof with respect to fatiguability.

Polycrystalline graphite oriented in a particular plane (e.g., the x-y plane) may advantageously conduct heat very well. In an embodiment, any commercially available polycrystalline graphite is used to create the bars 116. In an embodiment, only polycrystalline graphite suitable for quantum orientation as described hereinabove is used to create the bars 116.

Advantageously, the graphite bars 116 represent a much simpler and less costly thermal management technique compared to heat pipes and other conventional solutions.

The thermal management apparatus 114 further includes a flexible adhesive 124 disposed between the portion of the bottom surface 122 of the graphite bars 116 overlapping or covering the processing chip 110 and the top surface of the processing chip 110.

The adhesive 124 has a bond area and a bond thickness. Graphite has a significant CTE mismatch relative to other materials (e.g., relative to other components of the system 100). In some cases, the bond thickness of the adhesive 124 is determined and implemented such that the CTE mismatch between the graphite bars 116 and the PCB 102 is mitigated to a level deemed acceptable for the mission.

In some cases, the adhesive 124 may be applied with a primer to enhance bonding.

Generally, the adhesive 124 has enough thickness to allow for a reduction in CTE mismatch and to balance between thermal performance and thermal fatigue. In some embodiments, the adhesive 124 may be stiffer (less flexibility).

In an embodiment, the adhesive 124 is a high flexibility adhesive. The adhesive 124 may have a low Young's modulus value and a high strain to failure (e.g., greater than 100%).

In an embodiment, the adhesive 124 is a thermal conductive adhesive to minimize the thermal resistance between the FPGA and the graphite bars 116 with a minimum thermal conductivity of 0.5 W/m·K.

In an embodiment, the adhesive 124 has low outgassing properties. The adhesive 124 may be an adhesive that meets NASA outgassing requirements for space applications. Low outgassing properties may include two criteria: a maximum total mass loss (TML) of 1.0 percent and maximum collected volatile condensable material (CVCM) of 0.10 percent.

In an embodiment, the adhesive 124 is an adhesive that adheres well to graphite, for example with a lap shear strength exceeding 200 psi when primed.

The adhesive 124 may be an adhesive with a wide survival temperature range (e.g., ranging from conditions during launch of a spacecraft from Earth to conditions in outer space). For example, the adhesive 124 may be selected or designed to have a temperature range of -55C to +125C and an optimal range of -40C to +100C.

The adhesive 124 complies to the CTE mismatch between the graphite bars 116 and the PCB 102 (i.e., between the graphite bars 116 and the processing chip 110, between the graphite bars 116 and the receiving and retaining member 126, and between the graphite bars 116 and the frame 108). The adhesive 124 mitigates the challenge of thermal fatigue of the flip chip package.

In general, the adhesive 124 is a flexible adhesive or glue with a thick enough bond line to reduce stress at the interfaces, but thin enough to promote the heat transfer.

The adhesive 124 is advantageously flexible to avoid problems found in conventional adhesives, such as solder joint cracks and adhesive fissures between the bars 116 and the flip chip package (e.g., due to temperature fluctuations and CTE mismatch). The adhesive 124 may combine many advantages, including a wide temperature range, meeting NASA outgassing requirements, strong adhesion, flexibility, and thermal conductivity.

The thermal management apparatus 114 further includes a receiving and retaining member 126. In some embodiments, the receiving and retaining member 126 may not be present.

The receiving and retaining member 126 is mounted on and thermally coupled to the frame 108. The receiving and retaining member 126 includes a recess (not visible) for receiving (and securing) the second end 120 of the graphite bars 116. Generally, the receiving and retaining member 126 (and its recess) is long enough to accommodate the graphite bars 116. The bars 116 and/or second ends thereof 120 may be specially adapted to be received and retained by the receiving and retaining member 126.

The receiving and retaining member 126 retains the graphite bars 116 in a fixed position relative to the frame. The receiving and retaining member 126 is mounted on the frame 108. The end frame may serve as a stiffener to provide rigidity for the apparatus 100.

The receiving and retaining member 126 further includes thermal adhesive (which may be the same as adhesive 124) disposed in the recess of the receiving and retaining member 126. The bars 116 are adhered to the receiving and retaining member 126 in the recess via the thermal adhesive. The thermal adhesive secures the graphite bars 116 in the receiving and retaining member 126 and thermally couples the graphite bars 116 to the receiving and retaining member 126 to facilitate heat flow from the graphite bars 116 to the receiving and retaining member 126 (or, in embodiments where the receiving and retaining member 126 is absent, the component to which the second end 120 of the graphite bars 116 is mechanically and thermally coupled).

The receiving and retaining member 126 may advantageously receive the bars 116 with sufficient space about the bars 116 for the thermal adhesive. In an embodiment, a precise amount of the thermal adhesive is applied to yield a controlled gap.

The receiving and retaining member 126 encompasses the second end 120 on all planes (x, y, and z) through the thermal adhesive 124. The thermal coupling from the bar end 120 to the receiving and retaining member 126 is most effective in the larger contact areas (y-z plane).

The receiving and retaining member 126 is thermally coupled to a heat sink. In other embodiments, the receiving and retaining member 126 may be thermally coupled to another component, such as a chassis or other frame, that creates a thermal path for heat to travel from the receiving and retaining member 126 to a heat sink. In such embodiments, the graphite bars 116 may be mounted such that the second end 120 is at or near the other component or heat sink using a thermal adhesive. Such an approach may be advantageous in some cases by reducing mass and assembly effort.

Thermal interfaces include: the FPGA to the graphite bars 116 through the adhesive 124; the graphite bars 116 to the receiving and retaining member 126 through the adhesive 124; the receiving and retaining member 126 to the frame 108; and the frame 108 to the heat sink.

PCB housing 104 acts as a heat sink for the system 100. The heat sink receives heat processed by the system 100 and in particular by the apparatus 114. The heat sink may include a spacecraft panel.

In an embodiment, the thermal flow of the system 100 is from the processing chip 110 to the graphite bars 116 to the receiving and retaining member 126 to the housing 104 and then to the spacecraft panel. The heat may then be radiated or otherwise expelled by the spacecraft panel.

An example visualization of the heat flow in the system 100 is shown in Figure 1B. Arrows denote the direction of heat flow away from the flip chip package (through top surface of processing chip 110), through the graphite bars 116 to the receiving and retaining member 126, and through the receiving and retaining member 126 to the PCB housing 104.

Advantageously, the bars 116 may demonstrate double the performance (conductivity) compared to other graphite solutions such as graphite straps (e.g., 800 or 1500 W/m-K depending on the orientation). For example, copper thermal conductivity is 385 W/m-K. The bars 116 may demonstrate thermal conductivity of up to 1700 W/m.K.

In an embodiment, the density of the copper is 8.9 g/cm³ compared to the density of the graphite at 2.3 g/cm³, and so 70% less weight is required for 4 times the conductivity.

Advantageously, heat dissipates from the top of the cooling apparatus 100 via the bars 116, i.e., the heat dissipates in the x axis as shown in Figure 1B. The heat further dissipates along the path shown in Figure 1B, from the bars 116 to the receiving and retaining member 126 and down along the x axis through the PCB mounting platform 104.

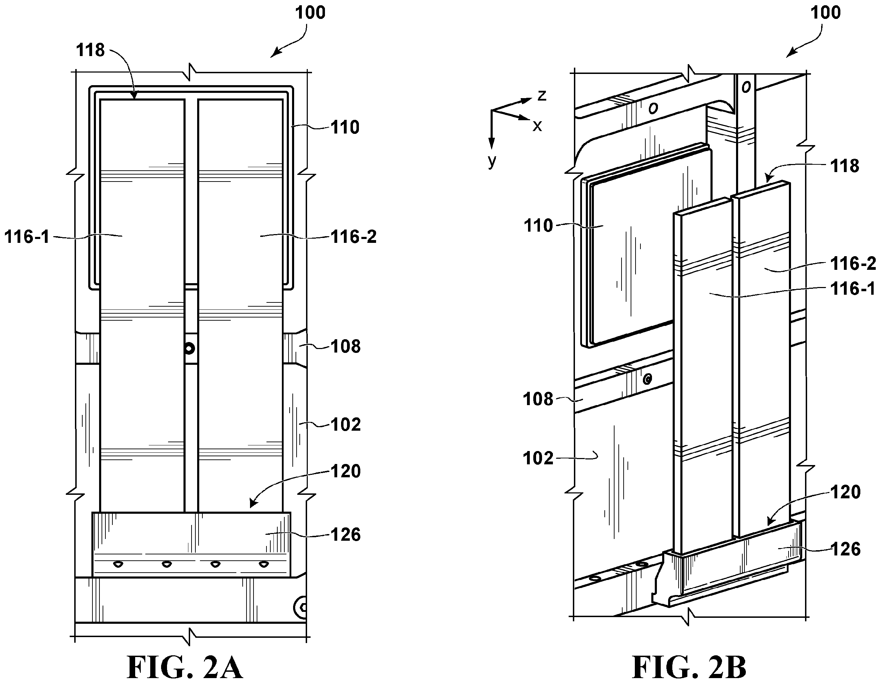

Referring now to Figure 2A, shown therein is a top view of the system 100 of Figures 1A and 1B.

Referring now to Figure 2B, shown therein is an isometric view of the system 100 of Figures 1A and 1B.

In Figures 2A and 2B, both bars 116 are present and are individually labelled as 116-1 and 116-2.

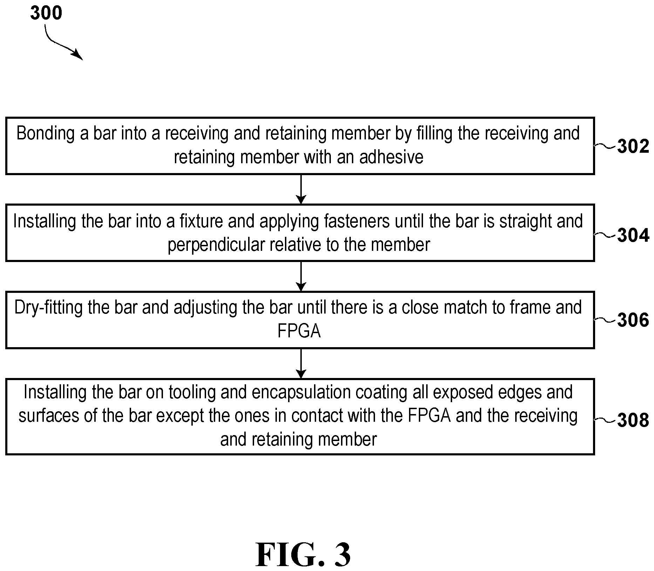

Referring now to Figure 3, shown therein is a flowchart of a method 300 for constructing a cooling apparatus, according to an embodiment. The cooling apparatus of Figure 3 may be the cooling apparatus 100 of Figures 1A, 1B, 2A, and 2B.

At 302, the method 300 includes bonding a bar into a receiving and retaining member by filling the receiving and retaining member with a thermal adhesive. In an embodiment, at 302, the bars 116 are bonded into the receiving and retaining member 126 with the thermal adhesive.

At 304, the method 300 further includes installing the bar into a fixture (which is an aid to create the cooling apparatus) and applying fasteners until the bar is straight and perpendicular relative to the receiving and retaining member. In an embodiment, at 304, the bars 116 are installed into the fixture and fasteners applied thereto until the bars 116 are straight and perpendicular relative to the receiving and retaining member 126.

At 306, the method 300 further includes dry-fitting the bar and adjusting the bar until there is a close match to a frame and FPGA. In an embodiment, at 306, the bars 116 are dry-fitted and adjusted until there is a close match to the frame and flip chip component (e.g., until the bars 116 are substantially perpendicular to one of the horizontal portions of the frame 108 and the flip chip component).

At 308, the method 300 further includes installing the bar on tooling and encapsulation coating all exposed edges and surfaces of the bar except for the areas in contact with the flip chip component and the receiving and retaining member 126 with an encapsulation coating. In an embodiment, at 308, the bars 116 are installed on tooling and all exposed edges and surfaces of the bars 116 are encapsulated with a coating.

The thickness of the adhesive used at the ends 118 and 120 may be designed and/or implemented to allow for a certain level of forgiveness, give, tolerance, and/or mismatch therein and/or thereof in order to reduce stress on the system 100, the processing chip 110, and/or any further apparatus or system in which the system 100 and/or the processing chip 110 are embedded or otherwise implemented.

While the above description provides examples of one or more apparatus, methods, or systems, it will be appreciated that other apparatus, methods, or systems may be within the scope of the claims as interpreted by one of skill in the art.

## Claims

1. A cooling apparatus for cooling electronic components, the cooling apparatus comprising:
at least one graphite bar mounted to a frame, the at least one graphite bar thermally conductive in a first axis and a second axis, the second axis being perpendicular to the first axis, the second axis parallel to a length of the at least one graphite bar;
the frame for mounting the at least one graphite bar, the frame comprising a receiving and retaining member mounted thereon and thermally coupled thereto for retaining the at least one graphite bar in a fixed position relative to the frame, the receiving and retaining member comprising a recess for receiving the at least one graphite bar;
a thermal adhesive disposed in the recess for adhering and thermally coupling the at least one graphite bar to the receiving and retaining member; and
a heat sink thermally coupled to the frame;
wherein heat is extracted from the at least one graphite bar or flows downward through the at least one graphite bar along the second axis to the receiving and retaining member, to the frame, and to the heat sink.

2. The cooling apparatus of claim 1, further comprising a digital printed circuit board ("PCB") mounted to a PCB mounting platform to which the frame is mounted and thermally coupled.

3. The cooling apparatus of claim 2, further comprising:
a flip chip electronic component mounted to the PCB at a bottom surface of the at least one graphite bar, the flip chip electronic component including an integrated circuit package, a top surface for dissipating heat to the at least one graphite bar, and a plurality of soldered contacts deposited onto chip pads of the flip chip electronic component for interconnecting the flip chip electronic component to external circuitry on the PCB; and
a flexible adhesive disposed between a portion of the bottom surface of the at least one graphite bar overlapping the top surface of the flip chip electronic component.

4. The cooling apparatus of claim 3, wherein approximately one third of the bottom surface of the at least one graphite bar overlaps the top surface of the flip chip electronic component.

5. The cooling apparatus of claim 3, wherein the flexible adhesive is applied with a primer to enhance bonding.

6. The cooling apparatus of claim 3, wherein the plurality of soldered contacts are soldered columns.

7. The cooling apparatus of claim 6, wherein the soldered columns are wrapped in copper.

8. The cooling apparatus of claim 3, wherein the plurality of soldered contacts are soldered balls.

9. The cooling apparatus of claim 1, wherein the at least one graphite bar is not conductive in a third axis perpendicular to the first axis and further perpendicular to the second axis.

10. The cooling apparatus of claim 1, wherein the at least one graphite bar is further conductive in a third axis perpendicular to the first axis and further perpendicular to the second axis.

11. The cooling apparatus of claim 1, wherein the at least one graphite bar is composed of polycrystalline graphite.

12. The cooling apparatus of claim 11, wherein the polycrystalline graphite is quantumly oriented such that conductivity is possible only in the first axis and in the second axis.

13. The cooling apparatus of claim 11, wherein the polycrystalline graphite is annealed.

14. The cooling apparatus of claim 1, wherein the at least one graphite bar is substantially rigid.

15. The cooling apparatus of claim 1, wherein the at least one graphite bar is compliant.
